(19) Europäisches Patentamt

European Patent Office

Office européen des brevets

(11) EP 0 920 029 A2

## (12) EUROPEAN PATENT APPLICATION

(43) Date of publication:
02.06.1999 Bulletin 1999/22

(51) Int. Cl.⁶: G11C 11/56

(21) Application number: 98309784.1

(22) Date of filing: 30.11.1998

(84) Designated Contracting States:
AT BE CH CY DE DK ES FI FR GB GR IE IT LI LU
MC NL PT SE
Designated Extension States:
AL LT LV MK RO SI

(30) Priority: 01.12.1997 US 67178 P

(71) Applicant:
TEXAS INSTRUMENTS INCORPORATED
Dallas Texas 75265 (US)

(72) Inventors:
• Miyai, Yoichi
  Toride City, Ibaraki 302 (JP)
• Nakamura, Hiroya
  Tsukuba City, Ibaraki 300-11 (JP)

(74) Representative:
Harris, Ian Richard et al
D. Young & Co.,
21 New Fetter Lane
London EC4A 1DA (GB)

### (54) Multi-state random acess memory

(57) A dynamic random access memory device having memory cells which store data in ternary form is disclosed. In a stand-by mode, a left side sense node (416a) is shorted to a right side sense node (416b) by operation of inner gates (426a and 426b). A ternary data signal is coupled to the shorted right and left sense nodes (416a and 416b) to generate a ternary data signal thereon. The left side sense node (416a) is then isolated from the right side sense node (416b). The left side sense node (416a) is driven by a sense amplifier (424a) to a high or low voltage according to the difference between the potential of the left side sense node (416a) and a first reference voltage (Vref1). The right side sense node (416b) is driven by a sense amplifier (424b) to a high or low voltage according to the difference between the potential of the right side sense node (416a) and a second reference voltage (Vref2). The first and second reference voltages (Vref1 and Vref2) are generated by dummy memory cells.

FIG. 4

## Description

<u>TECHNICAL FIELD</u>

The present invention relates generally to semiconductor memory devices, and more particularly to semiconductor memory devices having memory cells that store multiple logic states, for example to three state dynamic random access memory.

<u>BACKGROUND OF THE INVENTION</u>

A driving factor in semiconductor memory device manufacturing is the desire to attain higher density memory devices. Density in this context, refers to the number data bits that may be stored in a given area. There are numerous technological approaches to increasing memory device density. For example, in the case of dynamic random access memories (DRAMs), memory cells typically have a pass transistor and a storage capacitor. Variations on capacitor structure have been introduced to increase density. For example, "trench" capacitors increase vertical area while maintaining a relatively small horizontal area. "Stacked" capacitor structures place the majority of the capacitor area above the substrate.

While such specialized capacitors can increase DRAM density, both will require some minimum area on a semiconductor substrate. Accordingly, a primary approach to increasing memory device density, is to reduce the physical size of memory cells. Unfortunately, a decrease in memory cell size can result in a corresponding decrease in the strength of the data signal provided by the memory cell. This is particularly true for DRAMs. In a DRAM memory cell, as capacitor area decreases, so the does the amount of charge stored in the capacitor, and hence the data signal produced by the memory cell. As a result there is a limit to the amount by which memory cells can be reduced.

Conventional semiconductor memory devices typically include memory cells that store information in binary form. In the case of DRAMs, the storage capacitor is usually charged to high voltage to store a logic "1" value, or to a low voltage to store a logic "0" value. In operation, the capacitor is typically coupled to a bit line to generate a potential variation on the bit line. The logic value of the memory cell is then determined by comparing the potential variation on the bit line with a reference potential.

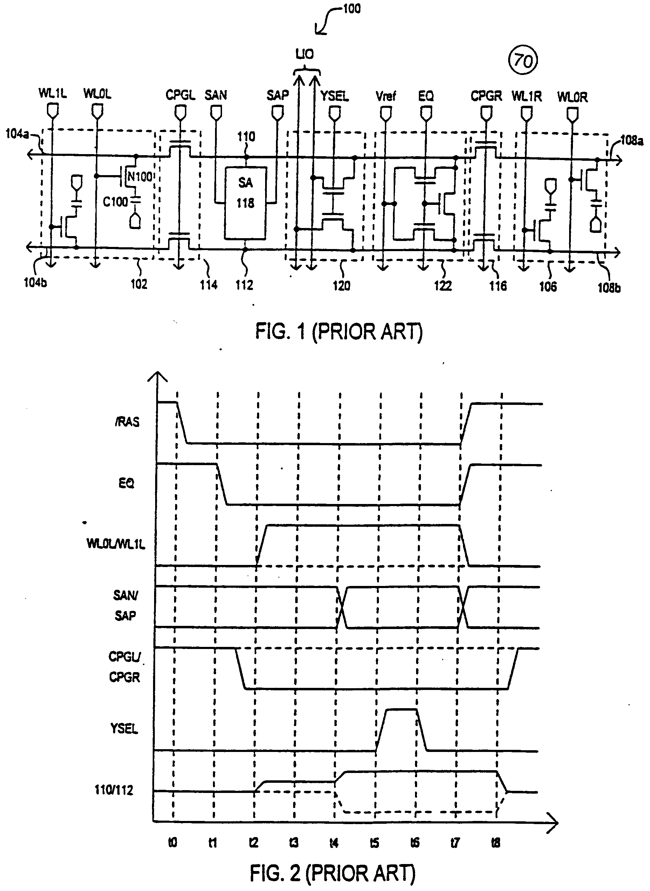

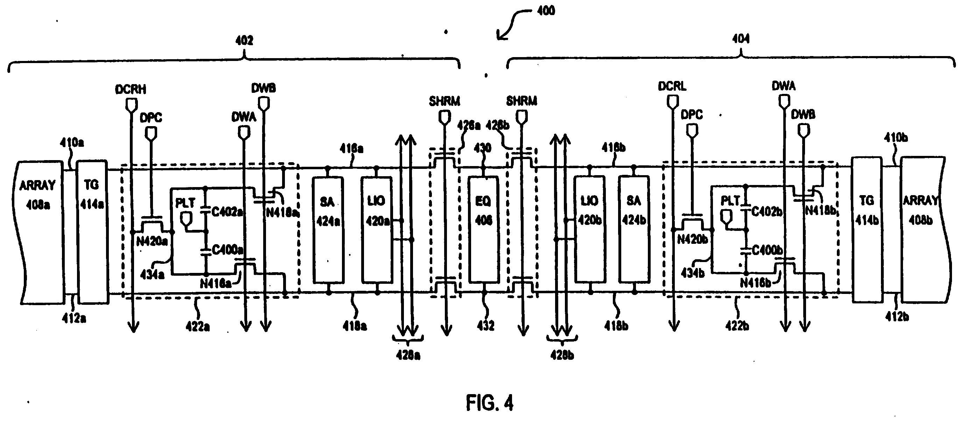

To more clearly understand conventional binary sensing arrangement, a prior art binary sense circuit is set forth in FIG. 1. The sense circuit is designated by the general reference character **100**, and includes a left memory cell array **102** having a pair of left bit lines (**104**a and **104**b), and right memory cell array **106** having a pair of right bit lines (**108**a and **108**b). The bit line pairs (**104**a/b and **108**a/b) are coupled to a pair of sense nodes (**110** and **112**) by left and right transfer gates (**114** and **116**). Disposed between the sense nodes (**110** and **112**) is a sense amplifier **118**, a local input/output (I/O) line circuit **120**, and a precharge and equalization circuit **122**.

The operation of the prior art binary sensing arrangement is illustrated by the timing diagram set forth in FIG. 2. The sense circuit enters an active mode by a control signal /RAS (a "row address strobe" signal) transitioning from a high to low voltage at time t0. At this point in time it is noted that the signal EQ is, and has been previously, at a high level. Consequently, the n-channel MOS transistors in the precharge and equalization circuit **122** are all turned on, and both the sense nodes **110** are shorted together and brought to a reference voltage, shown as Vref.

At time t1, the EQ signal falls from a high to a low voltage level. This turns the precharge and equalization circuit **122** off. The sense nodes (**110** and **112**) are thus isolated and precharged at the Vref potential. After time t1, one of the signals CPGL or CPGR falls low while the other remains high, isolating one pair of bit lines to the sense nodes (**110** and **112**) and maintaining the other pair of bit lines coupled to the sense nodes (**110** and **112**). In the case of FIG. 2, transfer gate **114** is remains enabled by the signal CPGL staying high and CPGR going low. The bit lines (**104**a/b and **108**a/b) remain precharged at the Vref potential.

At time t2, a word line is driven high, coupling a memory cell to a bit line. As shown in FIG. 1, the left memory cell array **102** is shown to include word lines, WL0L and WL1L, and the right memory cell array **104** is shown to include word lines WL0R and WL1R. For the description of FIGS. 1 and 2, it is assumed that word line WL0L is driven high. Transistor N100 is turned on, and capacitor C100 is coupled to bit line **104**a. As will be recalled, both bit lines (**104**a and **104**b) were previously precharged to Vref. Accordingly, when capacitor C100 is coupled to bit line **104**a, the potential of bit line **104**a will vary from the Vref potential while bit line **104**b would remain at Vref. It is assumed that capacitor C100 had a logic "1" value stored within (it was charged to a high voltage), and so bit line **104**a would rise above the Vref potential.

Because transfer gate **114** remains enabled, bit line **104**a is coupled to sense node **110** and bit line **104**b is coupled to sense node **112**, and the difference in the amount of charge on bit lines **104**a and **104**b, created by the activation of the word line, is shared with the sense nodes **110** and **112**, respectively. As a result, sense node **110** rises to a higher potential than sense node **112**.

At time t4, the sense amplifier **118** is activated, and the sense nodes (**110** and **112**) are driven to opposite power supply voltage levels according to the differential voltage between the sense nodes (**110** and **112**). In the particular circuit of FIG. 1, the sense amplifier **118** is activated by two complementary signals, SAN and SAP. Thus, because sense node **110** was at a getter potential than sense node **112**, sense node **110** is driven to high voltage and sense node **112** is driven to a low voltage. This is the primary step in the sensing of binary information in a DRAM. The potential of a bit line is changed by memory cell data to a potential that is either higher than, or lower than a reference voltage. The difference between the reference voltage and the bit line is amplified to generated a data signal.

Over the time period between times t5 and t6, the strong data signal on the sense nodes (**110** and **112**) is coupled to local I/O (LIO) lines, by operation of the LIO circuit **120**. The YSEL signal goes high, and sense nodes (**110** and **112**) are each coupled to a different LIO line. The data on the LIO lines can be subsequently amplified and output.

At time t7, the /RAS signal returns high. At about the same time, the word line WL0L returns low, isolating capacitor C100 from bit line **104**a. The EQ signal goes high, precharging the sense nodes (**110** and **112**) to the Vref voltage. It is noted that, the CGPL signal remains high, and so the bit line pair (**104**a and **104**b) are slow precharged to the Vref voltage. At time t8, the CPGR signal returns high.

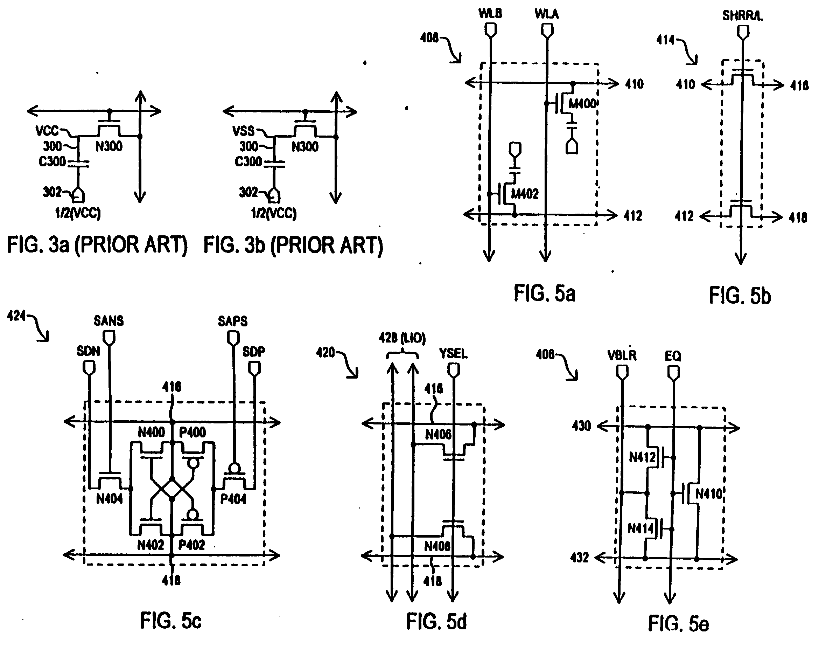

FIGS. 3a and 3b illustrate a prior binary storage scheme for DRAM memory cells. FIG. 3a illustrates the storage of a binary 1, while FIG. 3b illustrates the storage of a binary 0. For both cases, the voltage VCC is the high power supply voltage and the voltage VSS is the low power supply voltage (zero volts). The memory cell includes an n-channel MOS transistor N300 and storage capacitor C300. In the case of FIG. 3a, the storage capacitor C300 has a storage node **300** at the potential VCC and a plate node **302** at a potential ½VCC. In the case of FIG. 3b, the storage node **300** is at the low power supply potential VSS and the plate node is at the same ½VCC potential. For this binary storage scheme, it is advantageous to have the Vref potential used for sensing logic signals to be equal to ½VCC.

A very different approach to increasing memory device density involves abandoning the conventional binary storage approach, and instead, utilizing memory cells that can store more than one state. A drawback to such multi-state devices is that they often require manufacturing processes having specialized steps, and therefore are not always easily or reliably implemented.

## SUMMARY OF THE INVENTION

Particular and preferred aspects of the invention are set out in the accompanying independent and dependent claims. Features of the dependent claims may be combined with those of the independent claims as appropriate and in combinations other than those explicitly set out in the claims.

According to a preferred embodiment, a DRAM memory device includes standard memory cells which can store three different states. In a read operation, a storage capacitor from a standard memory cell is coupled to a common sense node, to create a potential variation thereon. The common sense node is formed by coupling a first sense node to a second sense node. Once a potential variation is generated on the common sense node, the first and second sense nodes are isolated from one another. Depending upon the state of the memory cell, the first and second sense nodes will be at a data high potential, a data intermediate potential, or a data low potential.

The first sense node is driven to a high or low logic level by a first sense amplifier, which compares the voltage on the first sense node with a first reference voltage. The first reference voltage is greater than the data intermediate potential, but less than the data high potential. The second sense node is driven to a high or low logic level by a second sense amplifier, which compares the voltage on the second sense node with a second reference voltage. The second reference voltage is less than the data intermediate potential, but greater than the data low potential. The resulting logic levels of the first and second sense nodes are used to convert the three state (ternary) information into binary information.

According to one aspect of the preferred embodiment, the first and second reference voltages are provided on first and second reference nodes by first and second dummy memory cells. The first and second dummy memory cells have storage capacitors that are coupled to the first and second reference nodes, respectively. The charge on the first dummy memory cell capacitor is selected so that the first reference voltage will be midway between the data high potential and the data intermediate potential. The charge on the second dummy memory cell is selected so that the second reference voltage will be midway between the data intermediate potential and the data low potential.

According to another aspect of the preferred embodiment, the storage capacitors of the dummy memory cells are equivalent in size to the storage capacitors of the standard memory cells. Predetermined voltages less than the power supply voltages are used to charge the storage capacitors of the dummy memory cells.

According to another aspect of the preferred embodiment, the storage capacitors of the dummy memory cells are smaller than storage capacitors of the standard memory cells. Potentials equivalent to the supply voltage are used to charge the storage capacitors of the dummy memory cells.

According to another aspect of the preferred embodiment, bit lines from one of two different memory cell arrays may be coupled to the first and second sense nodes by two sets of transfer gates.

For a better understanding of the invention and to show how the same may be carried into effect reference is now made by way of example to the accompanying drawings in which:

FIG. 1 is a schematic diagram of a prior art binary sensing circuit.

FIG. 2 is a timing diagram illustrating the operation of the circuit set forth in FIG. 1.

FIGS. 3a and 3b illustrate a DRAM cell for storing information in binary form according to the prior art.

FIG. 4 is a schematic diagram of a preferred embodiment.

FIGS. 5a-5e are schematic diagrams of circuits included within the preferred embodiment of FIG. 4.

FIGS. 6a-6c illustrate the ternary storage states of a DRAM, memory cell according to a preferred embodiment.

FIG. 7 is a timing diagram illustrating various control signals and nodes of the preferred embodiment set forth in FIG. 4.

FIGS. 8a and 8b are timing diagrams illustrating voltage levels of the sense nodes and reference nodes of the preferred embodiment of FIG. 4 during the reading and writing of the various ternary data signals.

FIG. 9 is a logic diagram illustrating the generation of the sense amplifier timing signals according to a preferred embodiment.

FIG. 10 is table illustrating the correspondence between ternary cell data and the potentials on local input/output (LIO) lines.

FIG. 11 is a table illustrating binary data cell equivalents to the ternary data cell values.

FIG. 12 illustrates a layout approach for the preferred embodiment.

## DETAILED DESCRIPTION OF THE EMBODIMENTS

Referring now to FIG. 4, a schematic diagram is set forth illustrating a sense circuit for a DRAM which stores data in a ternary form. The sense circuit is designated by the general reference character **400** and can be conceptualized as having a left side **402** and a right side **404** joined by an equalization circuit **406**. The left and right sides (**402** and **404**) of the preferred embodiment **400** have the same general elements. Accordingly, like elements on both sides will be referred to by the same reference character numeral, with the elements on the left side **402** ending with the letter "a", and elements on the right side **404** ending with the letter "b."

Each side (**402** and **404**) includes an array of DRAM memory cells (**408a** and **408b**) which provides a first bit line (**410a** and **410b**) and a second bit line (**412a** and **412b**). A transfer gate (**414a** and **414b**) couples the first bit line (**410a** and **410b**) to a first sense node (**416a** and **416b**), and the second bit line (**412a** and **412b**) to a second sense node (**418a** and **418b**). Three circuits are coupled between the first (**416a** and **416b**) and second sense nodes (**418a** and **418b**): a local input/output (LIO)

circuit (**420a** and **420b**), a reference voltage circuit (**422a** and **422b**), and a sense amplifier (**424a** and **424b**). The first sense nodes (**416a** and **416b**) and second sense nodes (**418a** and **418b**) are coupled to the equalization circuit **406** by internal gates (**426a** and **426b**).

Detailed schematic diagrams for some of the circuits included within the preferred embodiment **400** are set forth in FIGS. 5a-5e.

FIG. 5a sets forth a portion of a memory array **408**. The memory array **408** includes memory cells M400 and M402 which store data in three states, instead of in a binary form. In response to address signals, the memory array **408** generates a ternary data signal on a bit line. The even word line WLA couples a memory cell M400 to the first bit line **410**. The odd word line WLB couples memory cell M402 to the second bit line **412**. In the preferred embodiment, when an even word line is activated, a memory cell is coupled to a first bit line **410** while the odd word line remains at a precharge voltage, or vice versa. In this manner, the one bit line of a bit line pair provides a data signal, while the other bit line provides a precharge signal.

It is understood that because even word lines (such as WLA) couple memory cells to bit lines (**410a** and **410b**), these bit lines (**410a** and **410b**) can be considered "even" bit lines. Similarly, bit lines (**412a** and **412b**) can be considered "odd" bit lines. Along these same lines, the first sense nodes (**416a** and **416b**) can also be considered "even" sense nodes, as the activation of an even word line will place ternary data signals on the first sense nodes (**416a** and **416b**). It follows that the second sense nodes (**418a** and **418b**) can be considered "odd" sense nodes. In the operation of the preferred embodiment **400**, if an even word line is activated, the odd sense nodes (**418a** and **418b**) will provide reference voltages. Conversely, if an odd word line is activated, the even sense nodes (**416a** and **416b**) will provide reference voltages.

It is also noted that while the preferred embodiment **400** sets forth an arrangement having first and second sense amplifiers (**424a** and **424b**) disposed between memory arrays (**408a** and **408b**), an alternate arrangement could include the first and second sense amplifiers (**424a** and **424b**) being at opposite ends of one array.

FIG. 5b illustrates a transfer gate **414**. The transfer gate **414** couples the first and second bit lines (**410** and **412**) to a first a second sense node (**416** and **418**) to provide the ternary data signals to the sense amplifier **424**. The transfer gate **414** is shown to include two n-channel MOS transistors in parallel. The gate of both transistors receive an SHRR/L signal. The last letter of the signal identification indicates that there is a "left" side signal and a "right" side signal. Accordingly, the left transfer gated **414a** of FIG. 4 is activated by an SHRL signal, and the right transfer gate **414b** is activated by a SHRR signal. The SHRL/R signals may be "booted" signals. That is, when high, the signals that may exceed the maximum power supply voltage in order to eliminate the introduction of a threshold voltage drop between the bit lines (**410** and **412**) and sense nodes (**416** and **418**).

FIG. 5c illustrates a sense amplifier **424**. As shown in FIG. 4, in the preferred embodiment two sense amplifiers (**424a** and **424b**) are utilized. One sense amplifier **424a** drives its sense nodes (**416a** and **418a**) to opposite voltages in response to the differential voltage created by a ternary data signal on one sense node, and a first reference voltage on the other sense node. Similarly, the other sense amplifier **424b** drives its sense nodes (**416b** and **418b**) to opposite voltages in response to the differential voltage created by a ternary data signal on one of its sense nodes, and a second reference voltage on the other sense node.

In the particular embodiment of FIG. 5c, the sense amplifier is a CMOS sense amplifier having a first CMOS driver, formed from p-channel MOS transistor P400 and n-channel MOS transistor N400, cross-coupled to a second CMOS driver, formed from p-channel MOS transistor P402 and n-channel MOS transistor N402. The sources of transistors P400 and P402 are coupled to a high sense amplifier supply voltage, shown as SDP, by p-channel MOS transistor P404. The gate of transistor P404 is driven by a sense amplifier enable signal SAPS. In a similar manner, the sources of transistors N400 and N402 are coupled to a low sense amplifier supply voltage, shown as SDN, by n-channel MOS transistor N404. The gate of transistor N404 is driven by sense amplifier enable signal SANS. When enabled by a low SAPS signal and a high SANS signal, the sense amplifier **424** circuit will couple one of the sense nodes (**416** or **418**) to the SDP voltage, and the other sense node (**418** or **416**) to the SDN voltage.

FIG. 5d sets forth an LIO circuit **420**. The LIO circuit **420** is used to couple the data on a pair of sense nodes (**416** and **418**) to a pair of LIO lines **428**. In the preferred embodiment set forth in FIG. 4, it is the combination of the data on the left side LIO lines **428a** and the right side LIO lines **428b** that present binary signals in response to a ternary data signal. The LIO circuit **420** includes a first n-channel MOS transistor N406 for coupling tile first sense node **416** to one LIO line, and a second n-channel MOS transistor N408 for coupling the second sense node **418** to the other LIO line. The gates of transistors N406 and N408 are both driven by a YSEL signal.

FIG. 5e sets forth the equalization circuit **406** in a schematic diagram. Referring back to FIG. 4, the equalization circuit **406** functions in conjunction with the internal gates (**426a** and **426b**) and transfer gates (**414a** and **414b**) to precharge the sense nodes (**416a/b**, **418a/b**) and bit lines (**410a/b** and **412a/b**) to a precharge voltage, VBLR. The equalization circuit **406** is disposed between equalization nodes **430** and **432**, and is shown to include an n-channel MOS shorting transistor N410, and two n-channel MOS precharge transistors N412 and N414. The gates of transistors N410, N412 and N414 are commonly driven by an EQ signal. When the equalization circuit **406** is activated by a high EQ signal, the shorting transistor N410 shorts the equalization nodes (**430** and **432**) together, and the precharge transistors (N412 and N414) provide the precharge voltage VBLR to the equalization nodes (**430** and **432**). In the preferred embodiment **400**, the precharge voltage VBLR is midway between the supply voltages, VCC and VSS.

It is noted that the combination of the inner gates (**426a** and **426b**) and equalization nodes (**430** and **432**) can be considered together as an inner gate circuit that functions to couple the left side pair of sense nodes (**416a** and **418a**) to the right side pair of sense nodes (**416b** and **418b**.

Referring back to FIG. 4, the reference voltage circuits (**422a** and **422b**) and internal gates (**426a** and **426b**) are shown in detail. In the preferred embodiment **400**, both reference circuits (**422a** and **422b**) employ dummy cells to generate a reference voltage. The first reference voltage circuit **422a** is shown to include two dummy memory cells. The first dummy memory cell includes pass transistor N416a and storage capacitor C400a. The second dummy memory cell includes pass transistor N418a and storage capacitor C402a. The first dummy memory cell is coupled to the second sense node **418a** by even dummy word line signal DWLA. DWLA is high whenever an even word line, in either memory cell array **408a** or **408b**, is driven high. The second dummy memory cell is coupled to the first sense node **416a** by odd dummy word line signal DLWB whenever an odd word line, in either memory cell array **408a** or **408b**, is drive high. Storage capacitors C400a and C402a have a common storage node **434a** that is coupled to a first reference charge potential DCRH by an n-channel MOS dummy precharge transistor N420a. The opposing nodes of capacitors C400a and C402a are coupled to a plate node. The gate of transistor N420a is driven by a dummy precharge signal DPC.

The second reference voltage circuit **422b** has the same general configuration as the first reference voltage circuit **422a**: a first dummy memory cell (N416b and C400b), a second dummy memory cell (N418b and C402b), and a dummy precharge transistor N420b for coupling storage nodes of the capacitors C400b and C402b to a second reference charge potential DCRL. The difference between the first and second reference voltage circuits **422a** and **422b** is the magnitude of the reference charge potentials (DCRH and DCRL). The magnitude of the two reference charge potentials (DCRH and DCRL) will be discussed below.

It is understood that while the FIG. 4 illustrates a dummy capacitor pair (C400a/C402a and C400b/C402b) within each reference voltage circuit (**422a** and **422b**) each pair could be replaced by a single capacitor.

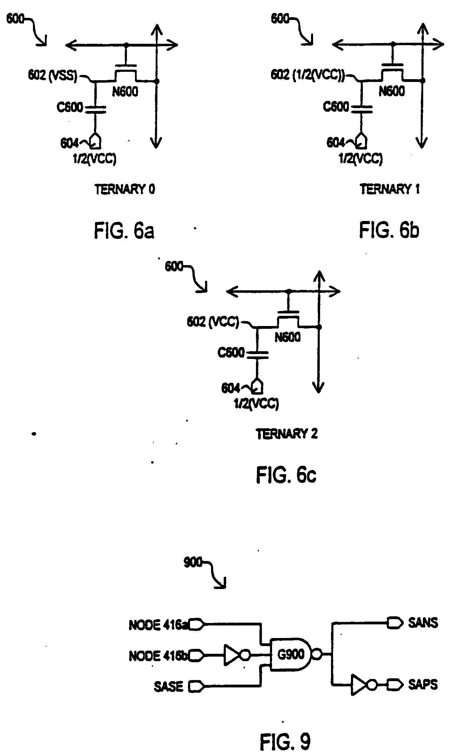

In order to assist in the understanding of the operation of the preferred embodiment **400**, the particular ternary storage approach of the preferred embodiment will now be reviewed. Referring now to FIGS. 6a-6c, the three states of a DRAM cell according to the preferred embodiment are set forth in a schematic diagram. The memory cell is designated by the general reference character **600**, and includes a pass transistor N600 and storage capacitor C600. The storage capacitor has a storage node **602** and a plate node **604**. In the preferred embodiment storage scheme, the plate node **604** is maintained at plate voltage of ½VCC, where VCC is the high power supply, and VSS is the low power supply (zero volts). FIG. 6a shows the voltage levels for a logic "0" value, in which the storage node **602** is charged to the low power supply voltage VSS. FIG. 6b shows the voltage levels for a logic "1" value, in which the storage node **602** is charged to a ½VCC voltage level. FIG. 6c shows the voltage levels for a logic "2" value, in which the storage node is charged to the high power supply voltage VCC. In the preferred embodiment, the plate nodes of the memory cells the same array are commonly connected.

Having described the preferred embodiment **400** in detail, the operation of the preferred embodiment **400** will now be described in conjunction with a series of timing diagrams.

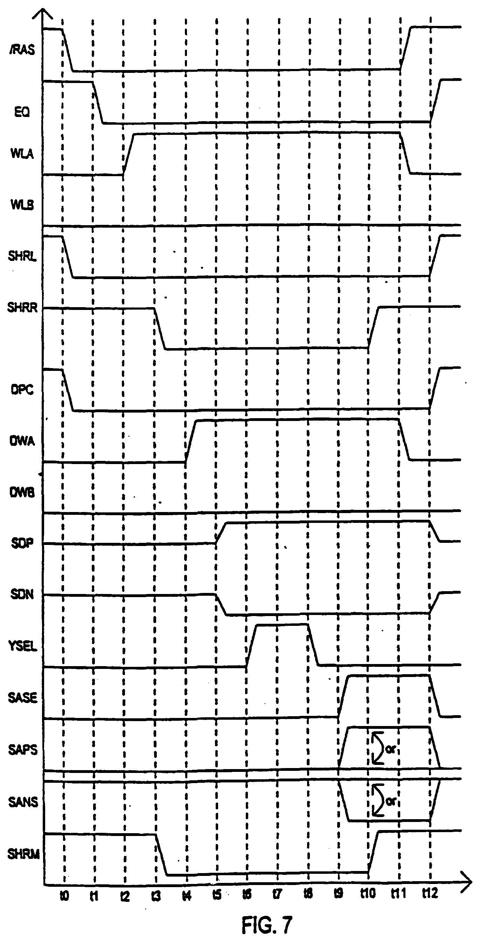

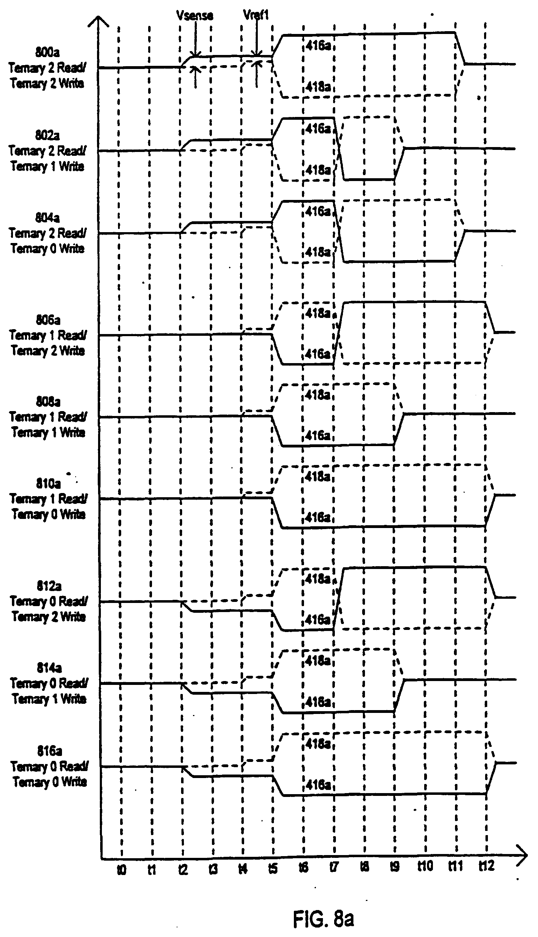

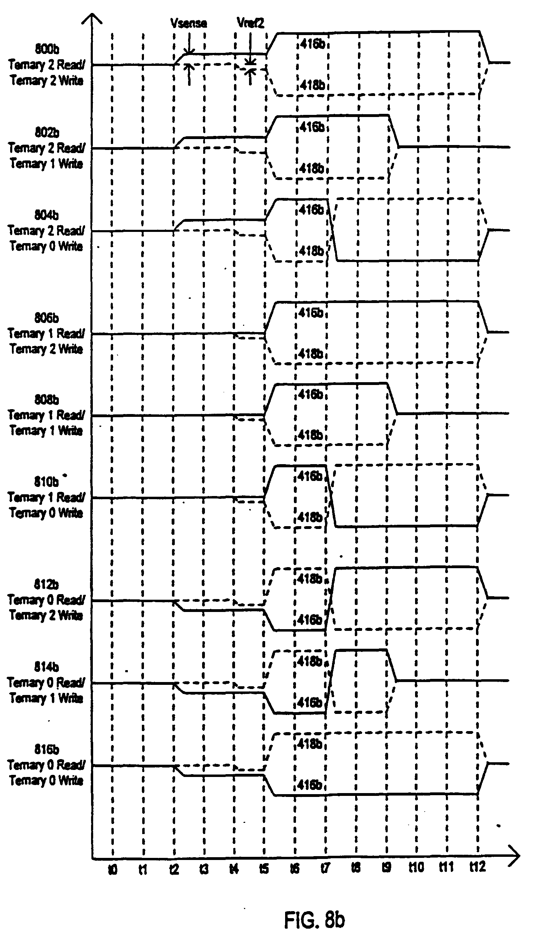

The operation of the preferred embodiment **400** is best understood with reference to FIGS. 4 and 5a-5e, in conjunction with FIGS. 7, 8a and 8b. FIG. 7 is a timing diagram illustrating the response of various signals used in the operation of the preferred embodiment **400**. FIG. 8a is a timing diagram illustrating the response of the first sense node **416a** and first reference node **418a** for the various possible read-write logic operations that may occur in the operation of the preferred embodiment. Similarly. FIG. 8b is a timing diagram which illustrates the response of the second sense node **416b** and second reference node **418b** for same combinations of read-write operations set forth in FIG. 8a.

Prior to time t0, the preferred embodiment **400** is in the stand-by state. In this state the bit lines, sense nodes and equalization nodes are all precharged to the voltage ½VCC. Referring now to FIGS. 4 and 5a-5e in conjunction with FIG. 7, it is shown that prior to time t0, the signal EQ is high, and so the equalization circuit **406** is active. The word lines (represented by the even and odd word lines WLA and WLB) are all low, isolating the memory cell storage capacitors from the bit lines (**410a/b** and **412a/b**). Further, the dummy word lines (DWA and DWB) are also low, isolating the dummy memory cells from the sense nodes (**416a/b** and **418a/b**). In contrast, the SHRL, SHRR and SHRM signals are all high, enabling both the left and right transfer gates (**414a**), as well as the internal gates (**426a** and **426b**). As a result, the first bit lines (**410a** and **410b**), first sense nodes (**416a** and **416b**), and equalization

node **430** are shorted together. In the same manner, the second bit lines (**412a** and **412b**), the second sense nodes (**418a** and **418b**), and the equalization node **432** are shorted together. Because the equalization circuit **406** is active, all of the above bit lines (**410a/b** and **412a/b**), sense nodes (**416a/b** and **418a/b**), and equalization nodes (**430** and **432**) are brought to the precharge voltage VBLR, which in the preferred embodiment is ½VCC.

In the stand-by state, the sense amplifiers (**424a** and **424b**) are disabled by the levels of their high and low supply voltages (SDP and SDN). As shown in FIG. 7, while the sense amplifier enable signals (SANS and SAPS) are active, the sense amplifier high and low supply voltages (SDP and SDN) are both at the ½VCC voltage. Because the sense nodes are also at the ½VCC voltage level, the sense amplifiers (**424a** and **424b**) are disabled.

The stand-by state also serves to charge the dummy memory cell capacitors (C400a/b) and C402a/b). Prior to time t0, the DPC signal is high, and the common storage node **434a** in the first reference voltage circuit **422a** is coupled to the first reference charge potential DCRH, and the common storage node **434b** in the second reference voltage circuit **422b** is coupled to the second reference charge potential DCRL.

Prior to time t0, the LIO circuits **420a** and **420b** are disabled, and the LIO lines **428a** and **428b** are isolated from the sense nodes (**416a/b** and **418a/b**). In addition, a rewrite timing signal SASE is also inactive (low). The SASE signal will be described in more detail below.

At time t0, the preferred embodiment transitions from a stand-by state to an active state. At this time, the bit lines from one array are isolated from the sense nodes on both the left and right sides of the array, and the dummy cell charging operation is terminated. Referring now to FIG. 7, at time t0, a row address strobe timing signal /RAS falls from a logic high to a logic low state. This transition may be the result of an externally applied /RAS signal, in the case of an asynchronous DRAM, or may be the result of an external clock signal, in the case of a synchronous DRAM.

In the example illustrated by FIG. 7, data is accessed from the right memory cell array **408b**. Accordingly, at about time t0, the signal SHRL goes low, disabling transfer gate **414a**, and isolating the left memory cell array **408a** from the rest of the preferred embodiment **400**. The SHRR signal remains high, and so bit line **410b** remains coupled to the first sense nodes (**416a** and **416b**) and equalization node **430**, and bit line **412a** remains coupled to the second sense nodes (**418a** and **418b**) and equalization node **432**.

Also at time t0, the DPC signal transitions from a high voltage to a low voltage. As a result, transistor N420a in the first reference voltage circuit **422a**, and transistor N420b in the second reference voltage circuit

422b, are turned off. It is noted that capacitors C400a and C402a are charged to the DCRH voltage, and capacitors C400b and C402b are charged to the DCRL voltage.

At time t1, the equalization function is terminated as the EQ signal falls from a high to a low voltage. Referring back to FIG. 5e, with the EQ signal low, transistors N410, N412 and N414 are turned off, and equalization node 430 is isolated from equalization node 432.

At time t2, ternary memory cell data is coupled to one bit line of a bit line pair. Word line WLA transitions from a low voltage to a high voltage. Referring back to FIG. 5a, it is recalled that word line WLA represents an even word line in the memory cell arrays (408a and 408b). Accordingly, a memory cell (for example memory cell M400) is coupled to the first bit lines 410b. However, it is recalled that the left transfer gate 414a is inactive while the right transfer gate 414b remains active, consequently, ternary cell data on bit line 410b is coupled to the first sense nodes (416a and 416b) and equalization node 430. The second sense nodes (418a and 418b) and equalization node 432 remain at the precharge voltage ½VCC. Thus, in the initial sensing stage, a ternary data signal is coupled to a common sense node formed by the first sense nodes (416a and 416b) being coupled together by transfer gates (426a and 426b).

For the purposes of this description it will be assumed that the memory cell data being read has a ternary value of "2". Further, it is assumed that the same value (ternary 2) is to be written back into the memory cell. The resulting response of the sense nodes for such an operation is shown by the waveforms 800a and 800b in FIGS. 8a and 8b, respectively. Waveform 800a illustrates the response of the first and second sense nodes (416a and 418a) of the preferred embodiment 400, while waveform 800b illustrates the response of the first and second sense nodes (416b and 418b) of the preferred embodiment 400.

Therefore, referring now to waveforms 800a and 800b, it is shown that at time t2. when the memory cell storage capacitor (charged to the ternary value of VCC) is coupled to bit line 410b by word line WLA going high, the first sense nodes (416a and 418a) begin to rise in potential above their respective second sense nodes (418a and 418b), which remain at the precharge potential ½VCC. The magnitude of the voltage differential is shown in FIGS. 8a and 8b as the voltage Vsense. The magnitude of Vsense is given the equation below.

$$Vsense = \left(\frac{VCC}{2}\right)\left(\frac{Ccell}{Csa+Cbl+Ccell}\right)$$

The VCC/2 term represents the voltage on the storage capacitor for a ternary 2 or ternary 0 value (i.e., VCC-½VCC or ½VCC-VSS). The term Ccell is the capacitance of the memory cell, the term Csa is the capacitance of the sense amplifier (i.e., a left and a right sense node), and Cbl is the capacitance of a bit line.

At time t3, the left pair of sense nodes (416a and 418b) and the right pair of sense nodes (416b and 418b) are isolated, trapping the voltage differential created by ternary cell data on the bit line 410b. The signal SHRR goes low, turning off the right transfer gate 414b, isolating the sense nodes (416a/b and 418a/b) from bit lines 410b and 412b. At the same time, the signal SHRM also goes low, turning off internal gates 426a and 426b, isolating the sense nodes (416a/b and 418a/b) from the equalization nodes (430 and 432). In this manner the two sense nodes forming the common sense node are isolated from one another.

At time t4, dummy word lines are activated, creating a first reference voltage on the one of the left sense nodes (416a or 418a) and a second reference voltage on one of the right sense nodes (416b or 418b). In the particular example illustrated by FIGS. 8a and 8b, the second sense node 418a on the left side 402 of the preferred embodiment is driven to a first reference voltage, while the second sense node 418b on the right side 404 is driven to a second reference voltage. As shown in FIG. 7, because an even word line (WLA) was activated to generate a ternary data signal on the first sense nodes (416a and 416b), dummy word line DWLA is activated to couple a dummy memory cell to the second sense nodes (418a and 418b). It is understood that had an odd word line been activated (for example word line WLB in FIG. 5a), dummy word line DWLB would be activated at this time period, while dummy word line DWLA would remain low.

This arrangement illustrates an important aspect of the preferred embodiment. When an even word line is activated, the first sense nodes (416a and 416b) serve as "sense" nodes in that they receive ternary data signals, while the second sense nodes (418a and 418b) function as reference nodes in that they provide different reference voltages. Conversely, when an odd word line is activated, the second sense nodes (418a and 418b) serve as the sense nodes, while the first sense nodes (416a and 416b) serve as the reference nodes.

Referring now to waveform 800a in FIG. 8a, it is shown that the voltage on the dummy word line capacitors (C400a and C402a) is selected so as to drive the second sense node 418a to a first reference voltage Vref1, which is half of the Vsense voltage. This is accomplished by generating the DCRH voltage according to the equation set forth below.

$$DCRH = \frac{VCC}{2} + \frac{VCC\left(\frac{Csa}{2}+Ccell\right)}{4(Csa+Cbl+Ccell)}$$

It can be shown that if the Vref1 signal is given by the following equation.

$$Vref1 = \left(\frac{VCC}{2} + DCRH\right)\left(\frac{Ccell}{\frac{Csa}{2} + Ccell}\right)$$

Substituting for DCRH will result in the relationship

$$Vref1 = \frac{1}{2}Vsense$$

The voltage on the dummy word line capacitors (C400b and C402b) on the opposing side of the preferred embodiment 400, is selected so as to drive the second sense node 418a to a second reference voltage VCC/2-Vref2. The Vref2 signal, like the Vref1 signal is also one half of the Vsense voltage, but is negative in polarity. This is accomplished by generating the DCRL voltage according to the equation set forth below.

$$DCRL = \frac{VCC}{2} - \frac{VCC\left(\frac{Csa}{2} + Ccell\right)}{4(Csa + Cbl + Ccell)}$$

Thus, as shown in waveform 800b of FIG. 8b, at time t4, the second sense node 418b falls below the ½VCC level.

The above selection of the DCRH and DCRL voltage levels has assumed that the size of the dummy cell capacitors is equivalent to the size of standard memory cell capacitors. One skilled in the art would recognize that instead of using the DCRH and DCRL voltages to charge the dummy cell capacitors, the size of the dummy cell capacitors could be reduced, and the supply voltages DCRH and DCRL could be replaced with supply voltages VCC and VSS. In such a case, the dummy cell capacitance is given by the equation below.

$$Cdummy = \frac{(Csa)(Ccell)}{4(Csa + Cbl) + 2Ccell}$$

At time t5, the sense amplifiers (424a and 424b) are activated, and the sense node pairs (416a/418a and 416b/418b) are driven to opposite supply voltage levels according to the differential voltage between them. Referring now to FIG. 7, at time t5, the sense amplifier high supply voltage SDP rises from ½VCC to a full VCC level. At the same time the sense amplifier low supply voltage SDN falls from ½VCC to VSS (zero volts). As shown in waveform 800a of FIG. 8a, prior to time t5, the potential of the first sense node 416a is higher than the potential of the second sense node 418a. As a result, when sense amplifier 424a is activated, the first sense node 416a is driven to the VCC potential and the second sense node 418a is driven to the VSS potential. The response of the other sense node pairs is shown in waveform 800b of FIG. 8b. At time t5, the first node 416b is driven to the VCC potential and the second node 418b is driven to the VSS potential.

At time t6, the data on the sense node pairs (416a/418a and 416b/418b) is coupled to the LIO lines (428a and 428b) by operation of the LIO circuits (420a and 420b). The YSEL signal rises from a low to high voltage. As shown in FIG. 5d, the high YSEL signal turns on transistors N406 and N408 coupling sense nodes 416 and 418 to LIO line pair 428.

At time t7, the YSEL signal remains high to account for a write operation. The example of FIG. 7 sets forth a case where no write operation takes place, or alternately, the same data value (ternary 2) is to be written back into the memory cell. Accordingly, there is no transition in voltage at time t7. Examples of read-write operations in which such a transition may occur at time t7 will be described in more detail below.

At time t8, the YSEL signal returns to a low voltage, disabling the LIO circuits (420a and 420b) and isolating the LIO lines (428a and 428b) from the sense node pairs (416a/418a and 416b/418b).

At time t9, a rewrite operation is initiated to drive the sense node pairs (416a/418a and 416b/418b) to opposite supply voltage levels, in order to write data back into the memory array (408a and 408b). The data write may occur in the write portion of a read/write operation, or to refresh the data stored within the memory arrays (408a and 408b).

Referring to FIG. 7, at time t9, an SASE signal goes high. The SASE signal is provided to either enable or disable the sense amplifiers (424a and 424b), depending upon the voltages at the sense node pairs (416a/418a and 416b/418b). In the event the sense node pairs have (416a/418a and 416b/418b) the same voltage levels, the sense amplifiers (424a and 424b) will remain enabled, and the SAPS signal will remain low, and the SANS signal will remain high. In the even the sense nodes pairs (416a/418a and 416b/418b) are driven to opposite voltages, the sense amplifiers (424a and 424b) will be disabled, to prevent the sense amplifiers (424a and 424b) from fighting each other during the write operation, and hence drawing excessive amounts of current. The signal SAPS will thus go high, and the SANS signal will go low, as long as SASE signal is high.

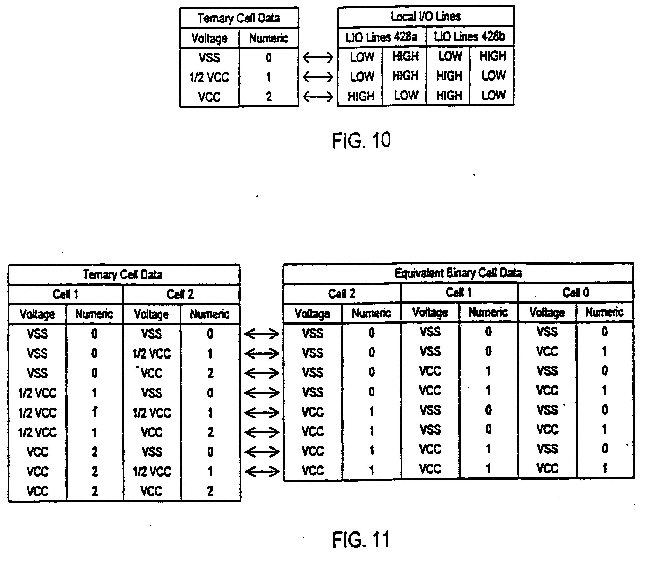

FIG. 9 illustrates a timing control circuit for generating the sense amplifier enable signals, SANS and SAPS set forth in FIG. 7. The timing control circuit is designated by the reference character 900 and is shown to include a three input NAND gate G900. One input to gate G900 is the voltage level at the first sense node 416a. A second input is the inverse of the voltage level at the second sense node 416b. The third input to gate G900 is the SASE signal. The output of gate G900 is the SANS signal. The SAPS signal is the inverse of the SANS signal.

In the particular example illustrated by waveforms 800a and 800b in FIGS.8a and 8b, the first nodes

(416a and 416b) are both at VCC at time t9. Accordingly, the SAPS signal will remain low, and the SANS signal will remain high.

At time t10, ternary data is written back into the memory cell arrays. As shown in FIG. 7, at time t10 the SHRM signal returns high, enabling internal gates (426a and 426b). The first nodes 416a and 416b are coupled together by way of equalization node 430, and the second nodes 418a and 418b are coupled together by way of equalization node 432. It is recalled that if the voltage levels of the two sense node pairs (416a/418a and 416b/418b) were equal (i.e., both at VCC or both at VSS), the sense amplifiers (424a and 424b) would remain enabled, and would operate together in the write function. In contrast, if the two sense node pairs (416a/418a and 416b/418b) were at opposite voltages (i.e., one at VCC the other at VSS) the sense amplifiers (424a and 424b) would be disabled, and the activation of the internal gates (426a and 426b) would short the oppositely charge sensed node pairs (416a/418a and 416b/418b) resulting in both nodes ending up at the ½VCC voltage level. The equalization circuit 406 may also become active, earlier in this case, to drive the sense nodes pairs (416a/418a and 416b/418b) to the ½VCC voltage level.

Also at time t10, the signal SHRR returns high, enabling the right side transfer gate 414b, coupling bit line 410b to the first sense nodes (416a and 416b), and bit line 412b to the second sense nodes (418a and 418b). Because word line WLA is still at a high voltage, data will be written back into the memory cell storage capacitor.

At time t11, the active cycle begins to conclude. The timing signal /RAS returns to a high voltage, and word line WLA returns to a low voltage. The corresponding dummy word line DWLA also returns to a low voltage. In this way, the storage capacitors of the standard and dummy memory cells are disconnected from the bit lines and sense nodes.

At time t12, the preferred embodiment is returned to the stand-by state by an equalization operation. The EQ signal goes high, and the first and second sense nodes (416a/b and 418a/b) are precharged and equalized to the ½VCC level. At the same time the SHRL signal returns high, enabling the left transfer gate 414a. Because both the left and right transfer gates (414a and 414b) are enabled at this time, the bit lines (410a/b and 412a/b) are also precharged and equalized to the ½VCC voltage level.

Also at time t12, the sense amplifiers (424a and 424b) are disabled, and the dummy memory cells within the reference voltage circuits (422a and 422b) are precharged. The SASE signal returns low, and the SDP and SDN supply voltages return to the ½VCC level. The DPC signal goes high, and the common storage nodes 434a is precharged to the DCRH voltage, while the common storage node 434b is precharged to the DCRL voltage.

Having described one possible data read/write operation. The remaining data read/write operations will be briefly discussed. Each of the waveforms in FIG. 8a represent the response of the left side sense nodes (416a and 418a) to a different read/write operation. FIG. 8b illustrates the response of the right side sense nodes (416b and 418b) to the same read/write operations of FIG. 8a.

Waveforms 800a/b, 802a/b and 804a/b set forth an operation that begins with the read of a ternary 2 data signal. Accordingly, the waveforms are generally the same from time t0 to time t7. The read ternary 2/write ternary 2 operation shown by waveforms 800a and 800b has already been described.

A read ternary 2/write ternary 1 operation is shown by waveforms 802a and 802b. Accordingly, the waveform 802a differs from waveform 800a, in that at time t7 the LIO lines 428a are driven to opposite voltage levels, reversing the differential potential at the sense nodes (416a and 416b), and causing the sense amplifier 424a to flip. The voltage at the sense nodes 416a and 418a are thus driven to opposite level at time t7. In addition, because the first sense nodes (416a and 416b) are at opposite voltage levels, at time t9, the sense amplifiers (424a and 424b) are disabled and the activation of internal gates (426a and 426b) result in the sense nodes (416a/b and 418a/g) being equalized to the ½VCC voltage level.

Waveforms 804a and 804b illustrate a read ternary 2/write ternary 0 operation. At time t7, both LIO line pairs 428a and 428b are driven to flip both sense amplifiers 424a and 424b. Accordingly, at time t7, the sense node voltages for the both left and right sides of the preferred embodiment 400 are reversed.

Waveforms 806a/b, 808a/b and 810a/b illustrate three operations that begin with a read ternary 1 operation. Waveforms 812a/b, 814a/b and 816a/b illustrate three operations that begin with a read ternary 0 operation. The functioning of the preferred embodiment 400 for these operations would be clear to one skilled in the art, in light of the description above.

Referring back to FIG. 4, an alternate way of conceptualizing the preferred embodiment will be described. The left transfer gate 414a can be considered a first data passing gate which couples the data from a bit line to a first sense node 416a. The combination of the inner gates (426a and 426b) can be considered a second data passing gate which couples the data signals from the bit line to a second sense node 416b. These first and second data passing gates (414a and 426a/b) are subsequently turned off, isolating the first sense node 416a from the second sense node 416b. The potential on the two sense nodes (416a and 416b) are then driven by two different sense amplifiers (424a and 424b) which drive the sense nodes (416a and 416b) by comparing the potential thereof with two different reference voltages (Vref1 and Vref2). Of course, for odd word lines, sense nodes 418a and 418b

would be considered the first and second sense nodes. Further, for data operations on the right memory cell array 408b, the right transfer gate 414b would be considered the first data passing gate, with the combination of inner gates (426a and 426b) functioning again as the second data transfer gates.

Referring now to FIG. 10, a table is set forth to more clearly illustrate the relationship between LIO line voltage levels and ternary cell data, according to a preferred embodiment. As shown in the figure, two of the ternary states (0 and 2) result in both pairs of LIO lines (428a and 428b) being driven to the same logic state. The third ternary state (1) results in the LIO line pairs (428a and 428b) being driven to opposite logic states.

While a ternary storage semiconductor memory device can provide increased data density, the semiconductor device must still interact with other devices configured for binary information. Thus, it is desirable to convert ternary information into binary information.

FIG. 11 illustrates a conversion scheme for translating ternary information to binary information. In the scheme of FIG. 11, two ternary data cells are used to generate the equivalent of three binary data cells. In other words two, three-state bits are translated into three, two-state bits. In the particular scheme of FIG. 11, the ternary cell data "22" is not used. It is understood that a different data set could be selected as the non-used combination.

The preferred embodiment 400 utilizes two sense amplifiers to sense ternary data. Such an arrangement departs from conventional binary DRAM arrangements in that a pair of sense amplifiers (as opposed to just one sense amplifier) must be coupled to each bit line. This constraint may give rise to difficulties in the physical placement of the components of the preferred embodiment 400 in an integrated circuit layout.

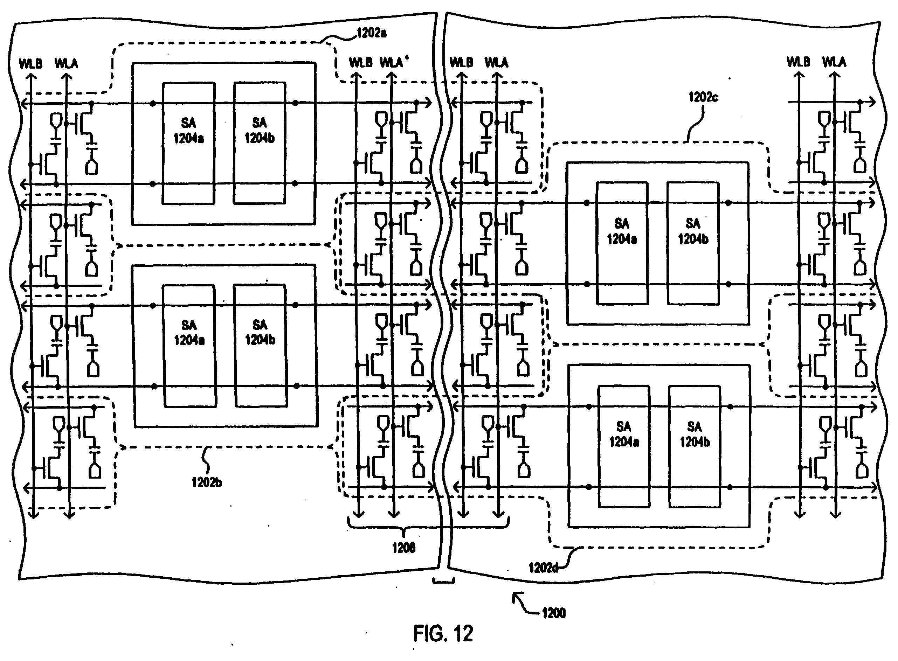

FIG. 12 represents an approach for laying out the preferred embodiment 400 in a semiconductor substrate. The layout approach is designated by the general reference character 1200, and shows the placement of four sense circuits, designated by the reference characters 1202a-1202d. It is understood that each of the circuits (1202a-1202d) includes two sense amplifier circuits, two LIO circuits, two reference circuits, two transfer gates, and one equalization circuit. To assist in the understanding of the layout, only the two sense amplifiers (designated by reference characters 1204a and 1204b) are shown in each of the circuits (1202a-1202d). The layout 1200 emphasizes the interchangeability of the terms "right" and "left" as used in the description of the preferred embodiment 400. For example, a memory cell array 1206 is shown situated between circuits 1202a and 1202c, and between circuits 1202b and 1202d. In such an arrangement, the memory array 1206 could serve as the "right" memory cell array for circuit 1202a and the "left" memory cell array for circuit 1202c.

It is also noted that in the layout of the preferred embodiment 400, separate wirings (conductive lines) are used to provide certain signals for the left side 402 and right sides 404 of the circuit. If reference is made to FIG. 4, the YSEL, SDN, SANS, SAPS, SDP, DPC, DWA and DWB signals are provided by different wirings for different sides. Furthermore, while the schematic diagram of FIG. 4 shows the line carrying the YSEL signals to be perpendicular to the bit lines, in the preferred layout, the YSEL lines is parallel to the bit lines. It is understood that alternate layout approaches could use one wiring for each of the signals. For example, the sense amplifier circuit pairs (1204a and 1204b) could be disposed in the vertical direction in FIG. 12, rather than the horizontal direction.

Although the present invention has been described in detail, with reference to various embodiments and aspects thereof, it should be understood that various changes, substitutions, and alterations could be made without departing from the spirit and scope of the invention.

Further aspects, embodiments and features of the invention are stated below in 45 sequentially numbered clauses.

1. A random access memory device, comprising:

a plurality of memory cells;
a plurality of first side bit lines coupled to the memory cells;
a first side transfer gate circuit coupling a bit line signal to a first side sense node;
an inner gate circuit coupling the bit line signal to a second side sense node;
a first sense amplifier coupled to the first sense node, the first sense amplifier driving the first side sense node to one of a plurality of predetermined potentials according to the difference between the potential of the first side sense node and a first reference voltage; and
a second sense amplifier coupled to the second side sense node, the second sense amplifier driving the second side sense node to one of the plurality of predetermined potentials according the difference between the potential of the second side sense node and a second reference voltage, the second reference voltage being different from the first reference voltage.

2. The random access memory device of clause 1, wherein:

the plurality of memory cells includes dynamic random access memory (DRAM) cells.

3. The random access memory device of clause 2, wherein:

the DRAM memory cells include storage capacitors for storing one of at least three different potentials.

4. The random access memory device of clause 1, wherein:

the first side transfer gate circuit couples a pair of bit lines to a first pair of sense nodes, the first pair of sense nodes including the first side sense node.

5. The random access memory device of clause 4, wherein:

the inner gate circuit couples the first pair of sense nodes to a second pair of sense nodes, the second pair of sense nodes including the second side sense node.

6. The random access memory device of clause 1, further including:

a first side reference node; and a first reference voltage circuit for generating the first reference voltage on the first side reference node, the first reference voltage circuit including a first dummy memory cell coupled to the first side reference node.

7. The random access memory of clause 7, wherein:

a second side reference node;

a second reference voltage circuit for generating the second reference voltage on the second side reference node, the second reference voltage circuit including a second dummy memory cell coupled to the second side reference node.

8. The random access memory of clause 7, further including:

a plurality of word lines having at least one even word line and at least one odd word line; the plurality of bit lines includes a bit line pair having a first bit line and a second bit line, the at least one even word line coupling memory cell data to the first bit line, the at least one odd word line coupling memory cell data to the second bit line; and the first side transfer gate circuit couples the first bit line to the first sense node and the second bit line to the first reference node.

9. The random access memory device of clause 8, wherein:

the inner gate circuit couples the first side sense node to the second side sense node, and the first side reference node to the second side reference node.

10. The random access memory device of clause 1, further including:

the first side transfer gate circuit couples a first side bit line signal to the first side sense node in a first side access operation, the first side transfer gate being disabled in a second side access operation; the inner gate coupled the first side bit line signal to the second sense node in the first side access mode, and couples a second side bit line signal to the first side sense node in a second side access operation; and a second side transfer gate circuit the second side bit line signal to the second side sense node in the second side access operation.

11. A multiple state memory sensing circuit, comprising:

a first transfer gate coupling at least a first bit line signal to a first side sense node; a second transfer gate coupling at least a second bit line signal to a second side sense node; a first amplifier coupled to the first sense node for driving the first sense node to a first predetermined voltage when the first sense node is greater than a first reference potential, and to a second predetermined voltage when the first sense node is less than the first reference potential; a second amplifier coupled to the second sense node for driving the second sense node to the first predetermined voltage when the second sense node is greater than a second reference potential, and to the second predetermined voltage when the second sense node is less than the second reference potential, the second reference potential being different than the first reference potential; and an inner gate circuit for coupling the first side sense node to the second side sense node.

12. The multiple state memory sensing circuit of clause 13, wherein:

the first predetermined voltage is equivalent to a high power supply voltage; and the second predetermined voltage is equivalent to the low power supply voltage.

13. The multiple state memory sensing circuit of clause 11, wherein:

the first transfer gate circuit includes a pair of insulated gate field effect transistors (IGFETs) coupled in parallel to a pair of bit lines.

14. The multiple state memory sensing circuit of clause 13, wherein:

the second transfer gate circuit includes a pair of IGFETs coupled in parallel to a pair of bit lines.

15. The multiple state memory sensing circuit of clause 11, wherein:

the first amplifier includes a high amplifier supply voltage and a low amplifier supply voltage, the high amplifier supply voltage being equivalent to a high power supply voltage and the low amplifier supply voltage being equivalent to a low power supply voltage when the first amplifier is in an active mode, the high amplifier supply voltage and the low amplifier supply voltage being at an intermediate voltage in an inactive mode, the intermediate voltage being intermediate the high power supply voltage and the low power supply voltage.

16. The multiple state memory sensing circuit of clause 11, wherein:

the first amplifier includes a pair of complementary cross-coupled IGFET drivers.

17. The multiple state memory sensing circuit of clause 11, further including:

a first reference node for providing the first reference voltage to the first amplifier; and a first dummy memory cell coupled to the first reference node for generating the first reference voltage on the first reference node, the first dummy memory cell including a first dummy storage capacitor.

18. The multiple state memory sensing circuit of clause 17, further including:

a first dummy precharge device for coupling the first dummy storage capacitor to a first reference precharged voltage, the first reference precharge voltage being less than a high power supply voltage.

19. The multiple state memory sensing circuit of clause 18, further including:

a second reference node for providing the second reference voltage to the second amplifier;

a second dummy memory cell coupled to the second reference node for generating the second reference voltage on the second reference node, the second dummy memory cell including a second dummy storage capacitor; and a second dummy precharge device for coupling the second dummy storage capacitor to a second reference precharge voltage, the second reference precharge voltage being greater than a low power supply voltage.

20. The multiple state memory sensing circuit of clause 17, further including:

a first bit line a standard memory cell coupled to the first bit line, the standard memory cell including a standard storage capacitor; and

the first transfer gate couples the first bit line to the first sense node.

21. The multiple state memory sensing circuit of clause 20, further including:

a first dummy precharge device for coupling the first dummy storage capacitor to a voltage equivalent of a high power supply voltage; and

the first dummy storage capacitor is smaller than the standard storage capacitor.

22. The multiple state memory sensing circuit of clause 21, further including:

a second reference node for providing the second reference voltage to the second amplifier; a second dummy memory cell coupled to the second reference node for generating the second reference voltage on the second reference node, the second dummy memory cell including a second dummy storage capacitor; a second dummy precharge device for coupling the second dummy storage capacitor to a voltage equivalent of a low power supply voltage; and the second dummy storage capacitor is smaller than the standard storage capacitor.

23. The multiple state memory sensing circuit of clause 11, wherein:

the inner gate circuit includes a first inner gate for coupling the first side sense node to a first equalization node, and a second inner gate for coupling the second side sense node to the first equalization node.

24. The multiple state memory sensing circuit of clause 23, wherein:

the inner gate circuit further includes a precharge circuit coupled to the first equalization node, the precharge circuit coupling the first equalization node to a precharge voltage, the precharge voltage being between a high power supply voltage and a low power supply voltage.

25. The multiple state memory sensing circuit of clause 11, further including:

a first local input/output (LIO) circuit for coupling the first sense node to a first LIO line; and a second LIO line circuit for coupling the second sense node to a second LIO line.

26. A sense and amplify arrangement for multi-state storage memory cells, the sense and amplify arrangement comprising:

a first pair of bit lines, including a first even bit line and a first odd bit line; a first even word line for coupling a first even line multi-state storage memory cell to the first even bit line when the first even word line is activated; a first odd word line for coupling a first odd line multi-state storage memory cell to the first odd bit line when the first odd word line is activated; a first pair of sense nodes including a first even sense node and a first odd sense node; a second pair of sense nodes including a second even sense node and a second odd sense node; a first transfer gate coupling the first pair of bit lines to the first pair of sense nodes; an inner gate circuit coupling the first pair of sense nodes to the second pair of sense nodes; a first reference voltage circuit coupled to the first pair of sense nodes, the first reference voltage circuit generating a first reference voltage on the first odd sense node when the even word line is activated, and generating the first reference voltage on the first even sense node when the odd word line is activated; and a second reference voltage circuit coupled to the second pair of sense nodes, the second reference voltage circuit generating a second reference voltage on the second odd sense node when the even word line is activated, and generating the second reference voltage on the second even sense node when the odd word line is activated, the second reference voltage being different from the first reference voltage.

27. The sense and amplify arrangement of clause 26, wherein:

the first even and odd line multi-state storage memory cells are dynamic random access memory (DRAM) cells, each having a pass transistor and a storage capacitor.

28. The sense and amplify arrangement of clause 27, wherein:

the first transfer gate includes a first transfer gate transistor coupling the even bit line to the first even sense node and a second transfer gate transistor coupling the odd bit line to the first odd sense node; and the first transfer gate transistor, the second transfer gate transistor and the pass transistors of the DRAM cells are of a first conductivity type.

29. The sense and amplify arrangement of clause 26, wherein:

the transistors of the first conductivity type are n-channel insulated gate field effect (IGFET) transistors.

30. The sense and amplify arrangement of clause 26, wherein:

the inner gate circuit includes a first inner gate transistor having a current passing path coupled to the first even sense node, and a second inner gate transistor having a current passing path coupled to the first odd sense node.

31. The sense and amplify arrangement of clause 30, wherein:

the inner gate circuit further includes a third inner gate transistor having its current passing path coupled to the second even sense node, and a fourth inner gate transistor having a current passing path coupled to the second odd sense node.

32. The sense and amplify arrangement of clause 31, further including:

a first equalization node; a second equalization node; a shorting device for coupling the first equalization node to the second equalization node; and the current passing path of the first inner gate transistor couples the first even sense node to the first equalization node, the current passing path of the third inner gate transistor couples the second even sense node to the first equalization node, the current passing path of the second inner gate transistor couples the first odd sense node to the second equalization node, and the current passing path of the fourth transistor couples the second odd sense node to the second equalization node.

33. The sense and amplify arrangement of clause 26, wherein:

the first reference voltage circuit includes a first dummy memory cell for coupling a first storage capacitor to the first even sense node when the odd word line is activated, for coupling the first storage capacitor to the first odd sense node when the even word line is activated; and the second reference voltage circuit includes a second dummy memory cell for coupling a second storage capacitor to the second even sense node when the odd word line is activated, and for coupling the second storage capacitor to the second odd sense node when the even word line is activated.

34. The sense and amplify arrangement of clause 26, further including:

a second pair of bit lines, including a second even bit line and a second odd bit line; a second even word line for coupling a second even line multi-state storage memory cell to the second even bit line when activated; a second odd word, line for coupling a second odd line multi-state storage memory cell to the second odd bit line when activated; and a second transfer gate coupling the second pair of bit lines to the second pair of sense nodes.

35. A method for reading data from multiple state memory cells, the method comprising the steps of:

shorting a first sense node to a second sense node to form a common sense node; coupling a multiple state signal to the common sense node; isolating the first sense node from the second sense node; driving the first sense node to a first predetermined potential or a second predetermined potential according to the difference in potential between the first sense node and a first reference voltage; and driving the second sense node to the first predetermined potential or a second predetermined potential according to the difference in potential between the second sense node and a second reference voltage.

36. The method of clause 35, wherein:

the step of shorting the first and second sense nodes includes activating an inner gate circuit disposed between the first and second sense node; and the step of isolating the first sense node from the second sense node includes de-activating the inner gate circuit.

37. The method of clause 35, wherein:

the step of shorting the first and second sense nodes includes precharging the first and second sense nodes to a precharge voltage.

38. The method of clause 37, wherein:

the precharge voltage is midway between a high power supply voltage and a low power supply voltage.

39. The method of clause 37, wherein:

the step of shorting the first and second sense nodes includes shorting a pair of bit lines to the precharge voltage.

40. The method of clause 37, wherein:

the first reference potential is greater than the precharge voltage; and the second reference potential is less than the precharge voltage.

41. The method of clause 40, wherein:

the step of driving the first sense node includes activating a first sense amplifier having a first input node coupled to the first sense node and a second input node coupled to the first reference potential; and the step of driving the second sense node includes activating a second sense amplifier having a first input node coupled to the second sense node and a second input node coupled to the second reference potential.

42. The method of clause 37, wherein:

the step of driving the first sense node includes driving the first sense node to the first predetermined potential if the first sense node potential is greater than the first reference voltage, and driving the first sense node to the second predetermined potential if the first sense node potential is less than the first reference voltage; and

the step of driving the second sense node includes driving the second sense node to the first predetermined potential if the second sense node potential is greater than the second reference voltage, and driving the second sense node to the second predetermined potential if the second sense node potential is less than the second reference voltage.

43. The method of clause 42, wherein:

the first predetermined potential and the third predetermined potential are equivalent to a high power supply voltage; and
the second predetermined potential and the fourth predetermined potential are equivalent to a low power supply voltage.

44. The method of clause 35, wherein:

the step of coupling a multiple state signal to the common sense node includes coupling a ternary data signal to the common sense node.

45. The method of clause 35, wherein:

the step of coupling a multiple state signal to the common sense node includes coupling a bit line to the common sense node.

**Claims**

1. A random access memory device, comprising:

a plurality of memory cells;
a plurality of first side bit lines coupled to the memory cells;
a first side transfer gate circuit coupling a bit line signal to a first side sense node;
an inner gate circuit coupling the bit line signal to a second side sense node;
a first sense amplifier coupled to the first sense node, the first sense amplifier driving the first side sense node to one of a plurality of predetermined potentials according to the difference between the potential of the first side sense node and a first reference voltage; and
a second sense amplifier coupled to the second side sense node, the second sense amplifier driving the second side sense node to one of the plurality of predetermined potentials according the difference between the potential of the second side sense node and a second reference voltage, the second reference voltage being different from the first reference voltage.

2. The random access memory device of claim 1, wherein:

the plurality of memory cells includes dynamic random access memory (DRAM) cells.

3. The random access memory device of claim 2, wherein:

the DRAM memory cells include storage capacitors for storing one of at least three different potentials.

4. The random access memory device of claim 1, 2 or 3, wherein:

the first side transfer gate circuit couples a pair of bit lines to a first pair of sense nodes, the first pair of sense nodes including the first side sense node.

5. The random access memory device of claim 4, wherein:

the inner gate circuit couples the first pair of sense nodes to a second pair of sense nodes, the second pair of sense nodes including the second side sense node.

6. The random access memory device of any preceding claim, including:

a first side reference node; and
a first reference voltage circuit for generating the first reference voltage on the first side reference node, the first reference voltage circuit including a first dummy memory cell coupled to the first side reference node.

7. The random access memory of claim 6, including:

a second side reference node; and
a second reference voltage circuit for generating the second reference voltage on the second side reference node, the second reference voltage circuit including a second dummy memory cell coupled to the second side reference node.

8. The random access memory of claim 6 or 7, further including:

a plurality of word lines having at least one even word line and at least one odd word line; wherein
the plurality of bit lines includes a bit line pair having a first bit line and a second bit line, the at least one even word line coupling memory cell data to the first bit line, the at least one odd word line coupling memory cell data to the second bit line; and

the first side transfer gate circuit couples the first bit line to the first sense node and the second bit line to the first reference node.

9. The random access memory device of claim 8 when appended to claim 7, wherein:

the inner gate circuit couples the first side sense node to the second side sense node, and the first side reference node to the second side reference node.

10. The random access memory device of any preceding claim, wherein:

the first side transfer gate circuit couples a first side bit line signal to the first side sense node in a first side access operation, the first side transfer gate being disabled in a second side access operation;

the inner gate couples the first side bit line signal to the second sense node in the first side access mode, and couples a second side bit line signal to the first side sense node in a second side access operation; and

a second side transfer gate circuit couples the second side bit line signal to the second side sense node in the second side access operation.

11. A multiple state memory sensing circuit, comprising:

a first transfer gate coupling at least a first bit line signal to a first side sense node;

a second transfer gate coupling at least a second bit line signal to a second side sense mode;

a first amplifier coupled to the first sense node for driving the first sense node to a first predetermined voltage when the first sense node is greater than a first reference potential, and to a second predetermined voltage when the first sense node is less that the first reference potential;

a second amplifier coupled to the second sense node for driving the second sense node to the first predetermined voltage when the second sense node is greater than a second reference potential, and to the second predetermined voltage when the second sense node is less than the second reference potential, the second reference potential being different than the first reference potential; and

an inner gate circuit for coupling the first side sense node to the second side sense node.

12. A sense and amplify arrangement for multi-state storage memory cells, the sense and amplify arrangement comprising:

a first pair of bit lines, including a first even bit line and a first odd bit line;

a first even word line for coupling a first even line multi-state storage memory cell to the first even bit line when the first even word line is activated;

a first odd word line for coupling a first odd line multi-state storage memory cell to the first odd bit line when the first odd word line is activated;

a first pair of sense nodes including a first even sense node and a first odd sense node;

a second pair of sense nodes including a second even sense node and a second odd sense node;

a first transfer gate coupling the first pair of bit lines to the first pair of sense nodes;

an inner gate circuit coupling the first pair of sense nodes to the second pair of sense nodes;

a first reference voltage circuit coupled to the first pair of sense nodes, the first reference voltage circuit generating a first reference voltage on the first odd sense node when the even word line is activated, and generating the first reference voltage on the first even sense node when the odd word line is activated; and

a second reference voltage circuit coupled to the second pair of sense nodes, the second reference voltage circuit generating a second reference voltage on the second odd sense node when the even word line is activated, and generating the second reference voltage on the second even sense node when the odd word line is activated, the second reference voltage being different from the first reference voltage.

13. A method for reading data from multiple state memory cells, the method comprising the steps of:

shorting a first sense node to a second sense node to form a common sense node;

coupling a multiple state signal to the common sense node;

isolating the first sense node from the second sense node;

driving the first sense node to a first predetermined potential or a second predetermined potential according to the difference in potential between the first sense node and a first reference voltage; and

driving the second sense node to the first predetermined potential or a second predetermined potential according to the difference in potential between the second sense node and a second reference voltage.

FIG. 1 (PRIOR ART)

FIG. 2 (PRIOR ART)

FIG. 4

EP 0 920 029 A2

FIG. 3a (PRIOR ART)   FIG. 3b (PRIOR ART)

FIG. 5a

FIG. 5b

FIG. 5c

FIG. 5d

FIG. 5e

600

602 (VSS) —

N600

C600

604 ~

1/2(VCC)

TERNARY 0

## FIG. 6a

600

602 (1/2(VCC)) —

N600

C600

604 ~

1/2(VCC)

TERNARY 1

## FIG. 6b

600

602 (VCC) —

N600

C600

604 ~

1/2(VCC)

TERNARY 2

## FIG. 6c

900

NODE 416a

NODE 416b

SASE

G900

SANS

SAPS

## FIG. 9

FIG. 7

FIG. 8a

FIG. 8b

| Ternary Cell Data | | | Local I/O Lines | | | |
|---|---|---|---|---|---|---|
| Voltage | Numeric | | LIO Lines 428a | | LIO Lines 428b | |
| VSS | 0 | ←→ | LOW | HIGH | LOW | HIGH |
| 1/2 VCC | 1 | ←→ | LOW | HIGH | HIGH | LOW |
| VCC | 2 | ←→ | HIGH | LOW | HIGH | LOW |

FIG. 10

| Ternary Cell Data | | | | | Equivalent Binary Cell Data | | | | | |
|---|---|---|---|---|---|---|---|---|---|---|
| Cell 1 | | Cell 2 | | | Cell 2 | | Cell 1 | | Cell 0 | |
| Voltage | Numeric | Voltage | Numeric | | Voltage | Numeric | Voltage | Numeric | Voltage | Numeric |
| VSS | 0 | VSS | 0 | ←→ | VSS | 0 | VSS | 0 | VSS | 0 |
| VSS | 0 | 1/2 VCC | 1 | ←→ | VSS | 0 | VSS | 0 | VCC | 1 |
| VSS | 0 | VCC | 2 | ←→ | VSS | 0 | VCC | 1 | VSS | 0 |
| 1/2 VCC | 1 | VSS | 0 | ←→ | VSS | 0 | VCC | 1 | VCC | 1 |
| 1/2 VCC | 1 | 1/2 VCC | 1 | ←→ | VCC | 1 | VSS | 0 | VSS | 0 |
| 1/2 VCC | 1 | VCC | 2 | ←→ | VCC | 1 | VSS | 0 | VCC | 1 |
| VCC | 2 | VSS | 0 | ←→ | VCC | 1 | VCC | 1 | VSS | 0 |
| VCC | 2 | 1/2 VCC | 1 | ←→ | VCC | 1 | VCC | 1 | VCC | 1 |
| VCC | 2 | VCC | 2 | | | | | | | |

FIG. 11

FIG. 12